# EUROPÄISCHE PATENTANMELDUNG

(11) **EP 0 792 003 A1**
(43) Veröffentlichungstag der Anmeldung: **27.08.1997**
(21) Anmeldenummer: 96120311.4
(22) Anmeldetag: 18.12.1996
(51) Int. Cl.: H02K 7/14, G06F 1/18, H05K 7/14

(54) **Haltevorrichtung für Steckkarten**

(30) Priorität: 23.02.1996 DE 19606797
(71) Anmelder: Funk Dreidimensional Entwicklungs- und Vertriebs GmbH, 72226 Simmersfeld (DE)
(72) Erfinder: Hein, Andre, 71083 Herrenberg (DE)
(74) Vertreter: Fleck, Hermann-Josef, Dr.-Ing.

(57) **Zusammenfassung**

Die Erfindung bezieht sich auf eine Haltevorrichtung für Steckkarten, die in Steckplätzen innerhalb eines Grundrahmens oder Gehäuses eingesetzt sind, wie z.B. bei einem Personal Computer. Dabei sind an den Steckkarten Haltestücke vorgesehen, mit denen sie mittels Befestigungsteilen in dem Grundrahmen oder dem Gehäuse gesichert sind. Eine zuverlässige Sicherung gegen ein unbeabsichtigtes Lösen bei einfacher Handhabung wird dadurch erreicht, daß die Befestigungsteile als steckkartenindividuelle Schieber ausgebildet sind und daß an dem Grundrahmen oder Gehäuse den Schiebern zugeordnete Schieberaufnahmen ausgebildet oder angebracht sind, in die die Schieber in Steckrichtung der Steckkarten einschiebbar und in denen sie verrastbar sind, und alternativ dadurch, daß die Befestigungsteile als steckkartenindividuelle Hebelvorrichtung in Form eines Zweigelenksystems mit einem in Steckrichtung der Steckkarte unteren Gelenkschenkel und einem diesen gegen den Grundrahmen oder das Gehäuse abstützenden Stützschenkel ausgebildet sind und daß der untere Gelenkschenkel im abgestützten Zustand das Haltestück gegen ein Bewegen entgegen der Steckrichtung sichert und im hochgeschwenkten Zustand das Haltestück und damit die Steckkarte freigibt.

## Beschreibung

Die Erfindung bezieht sich auf eine Haltevorrichtung für in Steckplätzen innerhalb eines Grundrahmens oder Gehäuses eingesetzte Steckkarten, die mit Haltestücken versehen und über diese mittels am Grundrahmen oder Gehäuse ankoppelbarer Befestigungsteile gegen ein Lösen aus den Steckplätzen gesichert sind.

Eine Haltevorrichtung dieser Art ist in der DE 44 03 907 A1 angegeben. Diese bekannte Haltevorrichtung dient zum Sichern von Steckkarten in einem Personal Computer. Das Gehäuse des Personal Computers nimmt als wesentlichen Bestandteil eine Hauptplatine auf, auf der Steckplätze mit entsprechenden Steckverbindern für Steckkarten vorgesehen sind. Beim Einsetzen der Steckkarten werden die elektrischen Verbindungen hergestellt, und in gewissem Maße werden die Steckkarten auch in den Steckverbindern gehalten. Um den mechanischen Halt zu verbessern, ist die Haltevorrichtung vorgesehen, die als Klemmleiste ausgebildet ist und über Haltestücke mit Halteflanschen der eingesteckten Steckkarten so mit dem Gehäuse verspannt wird, daß die Steckkarten unlösbar in ihren Steckplätzen gehalten werden. Zum Toleranzausgleich ist die Klemmleiste mit den Steckkarten zugeordneten, elastischen Lappen versehen, die sich federnd an den zugeordneten Halteflanschen der Steckkarten abstützen.

Bei dieser bekannten Haltevorrichtung werden alle Steckkarten gemeinsam verriegelt bzw. entriegelt, wobei zum Entriegeln die Klemmleiste entfernt wird. Dies hat jedoch den Nachteil, daß sich dann alle Steckkarten verschieben können und nicht mehr exakt in der als Schlitzrahmen ausgebildeten Gehäusewand gehalten sind. Außerdem ist die Klemmleiste auf eine ganz bestimmte Anzahl von Steckplätzen ausgelegt, so daß je nach Anzahl der Steckplätze unterschiedliche Klemmleisten erforderlich sind. Da die Steckplätze in der Hauptplatine sowohl mit horizontaler als auch mit vertikaler Steckrichtung eingebracht sein können, ist die Klemmleiste auch an verschiedene Gehäusewände mit entsprechenden Führungs- und Halteelementen anzupassen.

Es ist auch bekannt, die Steckkarten über ihre Halteflansche in der Gehäusewand zu verschrauben. Diese Verschraubung hat den Nachteil, daß ein Auswechseln der Steckkarten, was auch vom Benutzer des Personal Computers vorgenommen wird, nicht einfach ist und getrennte Verbindungselemente benötigt, die verlorengehen oder versehentlich in den Personal Computer fallen können, wo sie Schaden an der Elektronikplatine (Kurzschluß) verursachen können.

Der Erfindung liegt die Aufgabe zugrunde, eine Haltevorrichtung der eingangs erwähnten Art bereitzustellen, mit der die einzelnen Steckkarten zuverlässig gesichert sind und die einfach handhabbar ist.

Diese Aufgabe wird mit den in den Patentansprüchen 1 und 12 angegebenen Merkmalen gelöst.

Zum einen ist demnach also vorgesehen, daß die Befestigungsteile als steckkartenindividuelle Schieber ausgebildet sind und daß an dem Grundrahmen oder Gehäuse den Schiebern zugeordnete Schieberaufnahmen ausgebildet oder angebracht sind, in die die Schieber in Steckrichtung der Steckkarten einschiebbar und in denen sie verrastbar sind. Zum anderen ist vorgesehen, daß die Befestigungsteile als steckkartenindividuelle Hebelvorrichtung in Form eines Zweigelenksystems mit einem in Steckrichtung der Steckkarte unteren Gelenkschenkel und einem diesen gegen den Grundrahmen oder das Gehäuse abstützenden Stützschenkel ausgebildet sind und daß der untere Gelenkschenkel im abgestützten Zustand das Haltestück gegen ein Bewegen entgegen der Steckrichtung sichert und im hochgeschwenkten Zustand das Haltestück und damit die Steckkarte freigibt.

Diese Ausgestaltungen der Haltevorrichtung haben den Vorteil, daß stets nur die den betätigten steckkartenindividuellen Befestigungsteile zugeordneten Steckkarten verriegelt bzw. entriegelt werden, während die übrigen Steckkarten verriegelt bleiben und sich nicht lösen können. Für eine eindeutige, starre Festlegung brauchen die einzelnen Befestigungsteile keine Federelemente aufzuweisen, es können gewünschtenfalls jedoch Federelemente zum Festlegen der Haltestücke vorgesehen sein, um beispielsweise Toleranzen auszugleichen.

Für das Einsetzen der Schieber ist es günstig, wenn vorgesehen ist, daß die Schieberaufnahmen in an dem Grundrahmen oder Gehäuse angebrachten individuellen oder für mehrere oder alle Steckplätze einstückig geformten Basisteilen ausgebildet sind. Dabei können die gegebenenfalls einstückig ausgebildeten Basisteile einfach auf die erforderliche Länge entsprechend dem Bereich der Steckplätze angepaßt werden.

Ist vorgesehen, daß die Schieber die seitlich an den Steckkarten angebrachten Haltestücke mit einem quer zur Steckrichtung gerichteten Abschnitt übergreifen und daß an dem freien Endbereich des Abschnitts eine in Steckrichtung abgewinkelte Nase vorgesehen ist, die in einen zwischen dem Haltestück und dem zugekehrten Rand der Steckkarte vorgesehenen Spalt eingreift, so werden die Steckkarten stabil in ihren Steckplätzen festgehalten, und es besteht auch nicht die Gefahr, daß sie sich bei Erschütterungen lösen.

Ein relativ großer Haltebereich wird dadurch erzielt, daß das Haltestück einen rechtwinklig von der Steckkarte weg nach außen kragenden Halteabschnitt aufweist, der im eingesteckten Zustand der Steckkarte auf einer Abkantung des Grundrahmens oder Gehäuses aufliegt und mittels des unteren Abschnitts des Schiebers in dessen eingerastetem Zustand gesichert ist.

Eine für den Aufbau und die einfache Bedienung vorteilhafte Ausbildung des Schiebers besteht darin, daß der Schieber zwei im eingeführten Zustand in Steckrichtung verlaufende, senkrecht zu einer zugeordneten Wandung des Grundrahmens oder Gehäuses gerichtete Federschenkel aufweist, die an ihren in Steckrichtung liegenden, unteren Enden mittels eines Verbindungsstegs miteinander verbunden sind, und daß auf der Außenseite der Federschenkel in Steckrichtung verlaufende, senkrecht nach außen abstehende Führungsstege vorgesehen sind, auf deren von den Federschenkeln weggerichteten Außenseiten Rastelemente vorgesehen sind. Mit der Maßnahme, daß zwischen den Federschenkeln in deren oberem Bereich ein eingesetztes oder angeformtes Federelement vorgesehen ist, wird erreicht, daß die Federschenkel beim Zusammendrücken zum Entrasten über ihre Länge relativ gleichmäßig ausgelenkt werden und daß die Federwirkung im oberen Bereich des Schiebers verstärkt wird.

Zur besseren Führung und Festlegung des Schiebers in der Aufnahme ist es weiterhin günstig, wenn vorgesehen ist, daß der Schieber mindestens ein zwischen den Federschenkeln angeordnetes Stützelement aufweist, das im eingeführten Zustand des Schiebers zur Innenseite eines von dem Grundrahmen oder Gehäuse abgekehrten vorderen Wandabschnitt der Schieberaufnahme gerichtet ist.

Eine Ausbildung der Haltevorrichtung derart, daß die Schieberaufnahme von zwei in Steckrichtung verlaufenden, senkrecht zu der zugeordneten Wandung des Grundrahmens oder Gehäuses gerichteten seitlichen Wandabschnitten begrenzt ist und daß auf der Innenseite der seitlichen Wandabschnitte Gegenrastelemente vorgesehen sind, ergibt eine gute Führung und Lagerung für den Schieber, wobei eine zuverlässige Verrastung gewährleistet wird.

Ist vorgesehen, daß die Rastelemente und die Gegenrastelemente als Zahnungen mit in Steckrichtung angeordneten flachen und entgegen der Steckrichtung angeordneten steilen Flanken ausgebildet sind, so kann der Schieber stufenweise in der Aufnahme verrastet werden, und es können Fertigungs- oder Einbautoleranzen ausgeglichen werden.

Eine verbesserte Einführung und Abstützung des Schiebers läßt sich dadurch erzielen, daß die mit seitlichen Führungsnuten versehene Schieberaufnahme in ihrem mittleren unteren Bereich einen parallel zu den seitlichen Wandabschnitten ausgerichteten Mittelsteg aufweist, der zum Bilden eines T-förmigen Sicherungshakens auf seiner Vorderseite einen senkrecht daran verlaufenden vorderen Wandabschnitt trägt.

Durch die Maßnahme, daß die Schieber mit den Schieberaufnahmen über ein flexibles Band einstückig verbunden sind, wird vermieden, daß die Schieber verlorengehen.

Ist das Befestigungsteil als Hebelvorrichtung ausgebildet, so ist es für die Abstützung und Festlegung günstig, wenn der untere Gelenkschenkel auf seiner Unterseite einen Anlageschenkel, der im abgestützten Zustand flach auf dem Haltestück aufliegt, und einen darüber liegenden Halteschenkel aufweist, an dem der Stützschenkel mit seinem unteren Endbereich angelenkt ist, und daß der dem Grundrahmen oder Gehäuse zugewandte hintere Endbereich des Halteschenkels gelenkig mit einem an dem Grundrahmen oder dem Gehäuse angebrachten Basisteil verbunden ist.

Die Maßnahme, daß der nach oben gerichtete Stützschenkel mit einem Fixieransatz an einer bezüglich des Grundrahmens oder des Gehäuses festen Fixieraufnahme abstützbar ist, ergibt eine zuverlässige Abstützung und Festlegung des Haltestücks.

Eine bedienungsfreundliche Handhabung der Haltevorrichtung wird weiterhin dadurch erzielt, daß der obere Bereich des Stützschenkels in einen zu dem Grundrahmen oder Gehäuse gerichteten Fixierabschnitt ausläuft, der mit seiner hakenartig ausgebildeten Unterseite im hochgeschwenkten Zustand des Halteschenkels auf einem oberen Rand oder Auflagebereich des Grundrahmens oder Gehäuses festlegbar ist.

Eine einfache Festlegung der Schieberaufnahmen bzw. des oder der Basisteile an dem Grundrahmen oder Gehäuse wird dadurch erzielt, daß die Schieberaufnahmen bzw. das Basisteil mittels gegeneinander gerichteter Rasthaken in entsprechenden Durchbrüchen des Grundrahmens oder Gehäuses oder mittels einer an dem Grundrahmen oder dem Gehäuse vorgesehenen, den oberen Rand des Basisteils hintergreifenden Lasche und mittels einer einen Nocken im unteren Bereich des Basisteils aufnehmenden Aussparung des Grundrahmens oder Gehäuses festlegbar sind/ist.

Die Erfindung wird nachfolgend anhand von Ausführugnsbeispielen unter Bezugnahme auf die Zeichnungen näher erläutert. Es zeigen:
- Fig. 1A: einen Schieber für eine Haltevorrichtung,
- Fig. 1B: einen Querschnitt der Haltevorrichtung, wobei der Schieber in die Halteposition gebracht ist,
- Fig. 1C: einen Querschnitt der Haltevorrichtung, wobei der Schieber aus der Halteposition herausgebracht ist,
- Fig. 2: eine Vorderansicht mit einem in die Halteposition gebrachten und einem aus der Halteposition gebrachten Schieber,
- Fig. 3A: einen Querschnitt der Haltevorrichtung, wobei der Schieber mittels eines flexiblen Bandes mit einem Basisteil verbunden ist und zwei verschiedene Positionen des Schiebers dargestellt sind,
- Fig. 3B: einen weiteren Querschnitt der Haltevorrichtung gemäß Fig. 3A,
- Fig. 3C: eine teilweise geschnittene Vorderansicht des Schiebers gemäß Fig. 3B,
- Fig. 4A und Fig. 4B: einen Querschnitt bzw. eine Vorderansicht einer Haltevorrichtung mit mehreren nebeneinanderliegenden Basisteilen und daran angebundenen Schiebern,
- Fig. 4C: eine perspektivische Vorderansicht von mehreren mit einem einstückigen Basisteil verbundenen Schiebern,
- Fig. 4D: eine perspektivische Rückansicht der Haltevorrichtung gemäß Fig. 4C,
- Fig. 5a) bis d): ein weiteres Ausführungsbeispiel für die Haltevorrichtung mit einer Hebelvorrichtung in verschiedenen Stellungen,
- Fig. 6: eine perspektivische Vorderansicht der in Fig. 5 gezeigten Haltevorrichtung,
- Fig. 7A und 7B: jeweils einen Querschnitt der Haltevorrichtung nach Fig. 5 in zwei verschiedenen Stellungen der Hebelvorrichtung.

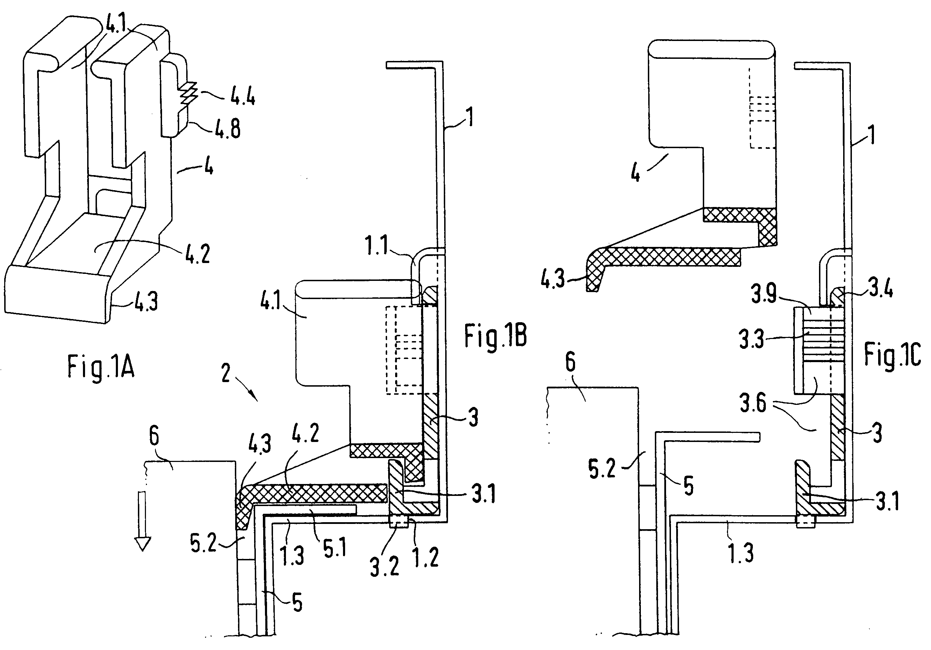

In den Fig. 1A bis 4D ist ein erstes Ausführugnsbeispiels einer Haltevorrichtung gezeigt, wobei in der Fig. 1A ein Schieber 4 dargestellt ist, der in eine z.B. in Fig. 1C gezeigte Schieberaufnahme 3.6 eines Basisteils 3 von oben nach unten einschiebbar ist. Wie in Fig. 1B ersichtlich, legt der Schieber 4 im eingeschobenen Zustand mit seinem unteren Bereich einen abgewinkelten Halteabschnitt 5.1 eines Haltestücks 5 an einer Abkantung 1.3 eines Gehäuses 1 fest. Das Haltestück 5 ist mit einem Rand einer Leiterplatte 6 verbunden, die in Richtung des Pfeils in einen Steckplatz eines Steckverbinders eingesteckt ist. Die Steckkarte 6 ist gegen ein Lösen aus dem Steckplatz über das Haltestück 5 und den in die Schieberaufnahme 3.6 eingesetzten Schieber 4 gesichert, da die Schieberaufnahme 3.6 mit dem Basisteil 3 an dem Grundrahmen 1 festgelegt ist.

Wie aus Fig. 1A ersichtlich ist, weist der Schieber 4 zwei seitliche in Steckrichtung verlaufende Federschenkel 4.1 auf, die senkrecht zu der Wandung des Grundrahmens 1 gerichtet sind (vgl. z.B. Fig. 1B). Die Federschenkel 4.1 sind an ihrer Unterseite über einen Verbindungssteg 4.2 miteinander verbunden. An seinem von der Wandung des Grundrahmens 1 weggerichteten vorderen Bereich läuft der Verbindungssteg 4.2 in eine im wesentlichen senkrecht nach unten gerichtete Nase 4.3 aus, die im eingesetzten Zustand in einen Spalt 5.2 zwischen dem Haltestück 5 und dem zugekehrten Rand der Steckkarte 6 hineinragt, so daß die Steckkarte 6 auch gegen ein in der Zeichenebene seitliches Bewegen gesichert ist, wie in Fig. 1B zu erkennen ist.

Fig. 1A zeigt weiterhin einen auf der Außenseite der Federschenkel 4.1 senkrecht abstehenden und in Einführrichtung zeigenden Führungssteg 4.8, wie er an beiden Federschenkeln 4.1 vorgesehen ist. Auf der von dem Federschenkel 4.1 weggerichteten Außenseite trägt der Führungssteg 4.8 ein als Zahnung ausgebildetes Rastelement 4.4 mit in Steckrichtung flachen und entgegen der Steckrichtung steilen Flanken.

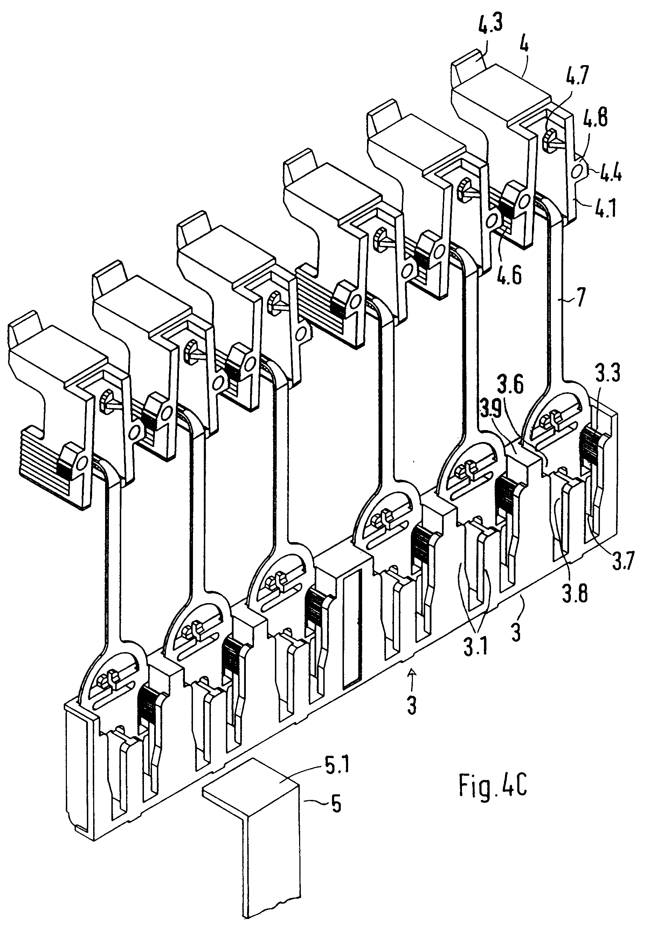

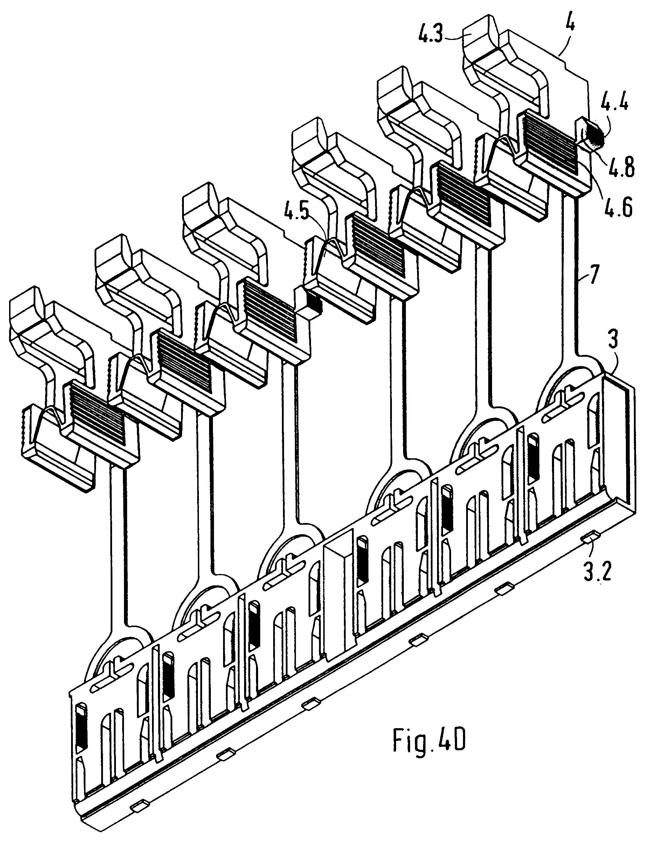

Wie z.B. in der Fig. 4C zu erkennen ist, sind in dem Basisteil 3 im Bereich der Schieberaufnahmen 3.6 jeweilige Führungsnuten 3.7 gebildet, in die die Führungsstege 4.8 eingeführt werden. Die Führungsnuten 3.7 werden durch einen dem Grundrahmen 1 zugekehrten hinteren Wandabschnitt, durch zwei senkrecht dazu und in Einführrichtung verlaufende seitliche Wandabschnitte 3.9 sowie durch vordere Wandabschnitte 3.1 gebildet. Auf der Innenseite der seitlichen Wandabschnitte 3.9 der Schieberaufnahmen 3.6 sind ebenfalls als Zahnungen ausgebildete Gegenrastelemente 3.3 vorgesehen, die an die Rastelemente 4.4 angepaßt sind und in die die Rastelemente 4.4 im eingesetzten Zustand eingreifen. Wie aus den Fig. 1B bis 4C jeweils erkennbar, wirken die im unteren, vorderen Bereich in der Mitte angeordneten vorderen Wandabschnitte 3.1 als Sicherungshaken, die hinter einen Abschnitt bzw. hinter ein Stützelement 4.7 des Schiebers 4 greifen, so daß dieser im eingeführten Zustand auch in seinem unteren Bereich an dem Basisteil 3 festgelegt ist. Wie am besten aus Fig. 4C zu erkennen ist, ist der mittlere vordere Wandabschnitt 3.1 des Basisteils über einen Mittelsteg 3.8 mit dem hinteren Wandabschnitt des Basisteils 3 verbunden. Hierdurch ist der untere Bereich der Schieberaufnahme 3.6 in zwei Bereiche mit jeweils zwei sich gegenüberliegenden Führungsnuten unterteilt, wobei der vordere Wandabschnitt 3.1 zwei Aussparungen freiläßt, durch die die beiden Federschenkel 4.1 im eingeführten Zustand nach vorne aus dem Basisteil 3 herausragen.

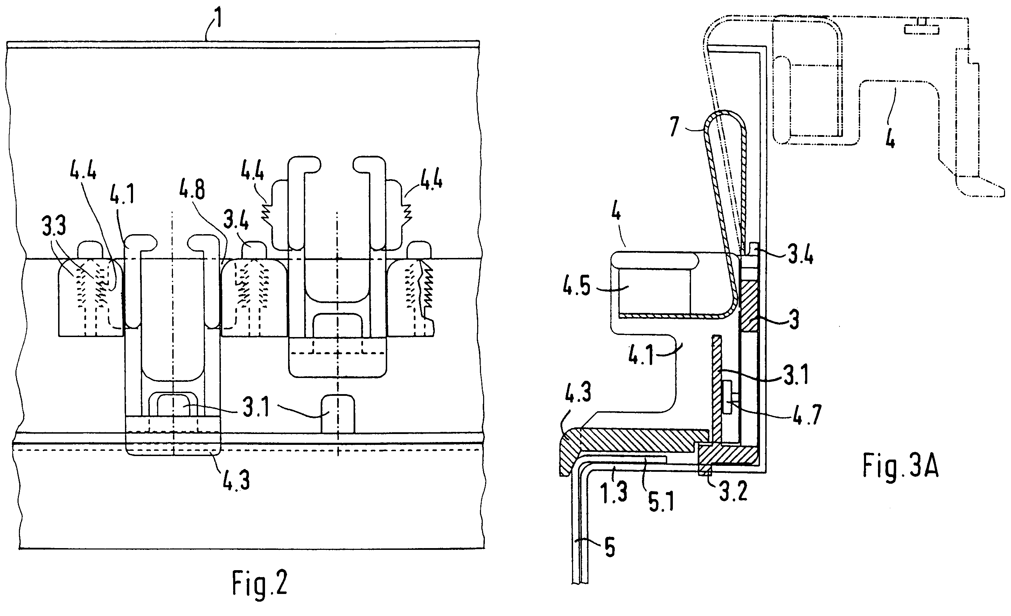

Zum Herausnehmen des Schiebers 4 aus der Aufnahme 3.6 werden die Federschenkel 4.1 zusammengedrückt, so daß die Rastelemente 4.4 aus den Gegenrastelementen 3.3 ausrücken und der Schieber 4 nach oben aus der Schieberaufnahme 3.6 herausgezogen werden kann, wie beispielsweise die Fig. 2 zeigt.

Zum Festlegen des Basisteils 3 an dem Grundrahmen 1 ist in diesem eine Lasche 1.1 herausgebogen, die einen Sicherungsabschnitt 3.4 am oberen Rand des Basisteils 3 hintergreift. Auf der Unterseite des Basisteils 3 ist ein Nocken 3.2 vorgesehen, der in eine entsprechende Aussparung 1.2 in der Abkantung 1.3 des Grundrahmens 1 ragt. Über die Länge des Basisteils 3 sind mehrere Sicherungselemente 3.4 und entsprechende Laschen 1.1 sowie Nocken 3.2 und Aussparungen 1.2 vorgesehen. Das Basisteil 3 kann durch diese Maßnahmen in einer Art Klipsvorgang an dem Grundrahmen 1 festgelegt werden.

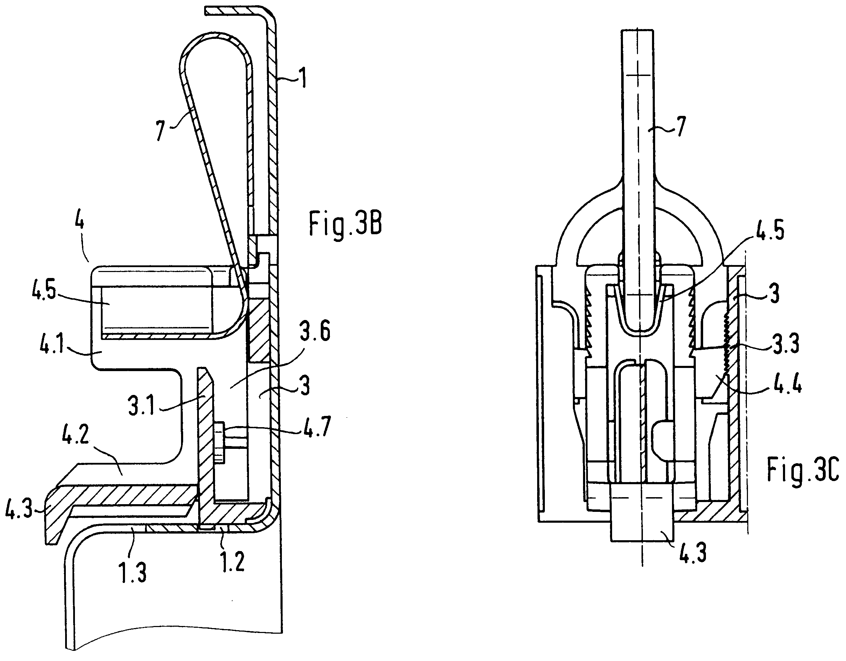

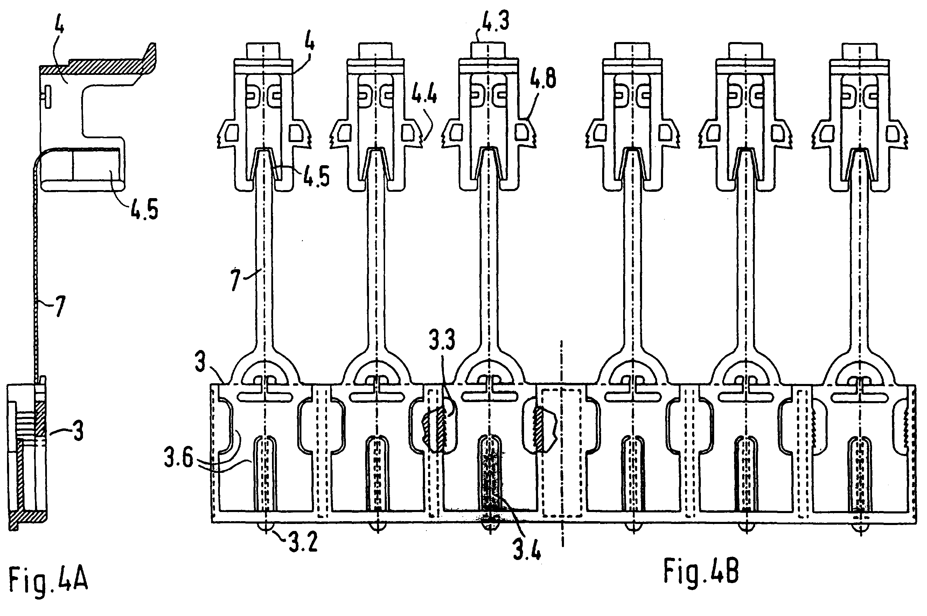

Gemäß den Fig. 3A bis 4D ist der Schieber 4 über ein flexibles Band 7 mit dem Basisteil 3 einstückig verbunden. Dabei ist das flexible Band 7 an dem Schieber 4 in dem oberen Bereich zwischen den beiden Federschenkeln 4.1 angebunden, wobei dieser Anbindungsbereich gleichzeitig ein V-förmiges oder U-förmiges Federelement 4.5 bildet. Dieses blattförmige Federelement 4.5 stützt die beiden Federschenkel 4.1 an ihrem freien Rand gegeneinander ab, so daß beim Zusammendrücken der Federschenkel 4.1 die Schenkel über ihre Länge relativ gleichmäßig ausgelenkt werden und die Endrastung verbessert wird. Die Ausbildung des Federelements 4.5 ist insbesondere in Fig. 3C deutlich zu erkennen. Die Fig. 3C zeigt auch die Anbindung des Bandes 7 an dem Basisteil 3 über einen bogenförmigen Anbindungsbereich. Diese Ausbildung ist auch aus Fig. 4B ersichtlich.

Die oberen Außenseiten der Federschenkel 4.1 können außerdem für eine bessere Griffigkeit eine Riffelung aufweisen, um einen Griffbereich 4.6 zu bilden.

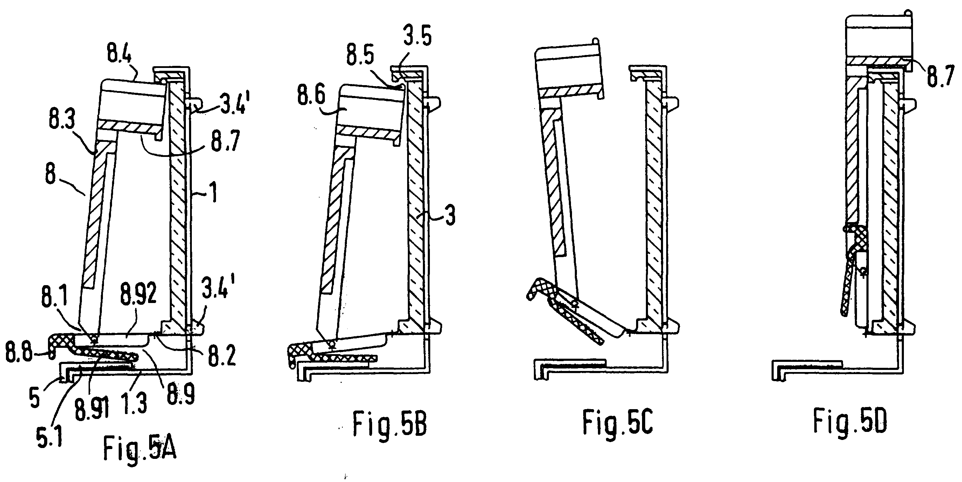

Die Fig. 5 bis 7B zeigen ein weiteres Ausführungsbeispiel der Haltevorrichtung 2. Dabei sind die Befestigungsteile als Hebelvorrichtungen 8 in Form eines Zweigelenksystems zur steckkartenindividuellen Festlegung ausgebildet.

Der Halteabschnitt 5.1 des Haltestücks 5 wird von einem in Steckrichtung der Steckkarte unteren Gelenkschenkel 8.9 übergriffen, der an seinem der Steckkarte zugekehrten freien Ende, wie bei dem vorangegangenen Ausführungsbeispiel, eine Nase 8.8 zum Übergreifen des Halteabschnitts 5.1 aufweist. Der untere Gelenkschenkel 8.9 teilt sich in einen Anlageschenkel 8.91, der mit dem Halteabschnitt 5.1 zusammenwirkt, und einen Halteschenkel 8.92 auf, wobei zwischen dem Anlageschenkel 8.91 und dem Halteschenkel 8.92 ein kleiner, spitzwinkliger Spalt freigelassen ist. Im Bereich des Spalts ist der Halteschenkel 8.92 an einer ersten Gelenkstelle 8.9 an einem nach oben gerichteten Stützschenkel 8.3 angelenkt, der an seinem oberen Ende in einen nach hinten zu dem Grundrahmen 1 gerichteten Fixierabschnitt 8.4 übergeht. Der Fixierabschnitt 8.4 weist auf seiner Oberseite an dem zu dem Grundrahmen 1 gerichteten Ende einen Fixieransatz 8.5 auf, der im abgestützten Zustand in eine Fixieraufnahme 3.5 an dem Basisteil 3 eingreift (siehe Fig. 5a) und 5b)). Der Halteschenkel 8.92 ist außerdem an seinem hinteren Ende über eine zweite Gelenkstelle 8.2, beispielsweise ein Filmscharnier, mit dem unteren Endbereich des Basisteils 3 verbunden.

Zum Festlegen des Halteabschnitts 5.1 und damit der Steckkarte wird der Fixierabschnitt 8.4 in der Fixieraufnahme 3.5 eingeschnappt, wobei die Elastizität des Halteschenkels 8.92 und des Stützschenkels 8.3 ausgenutzt werden.

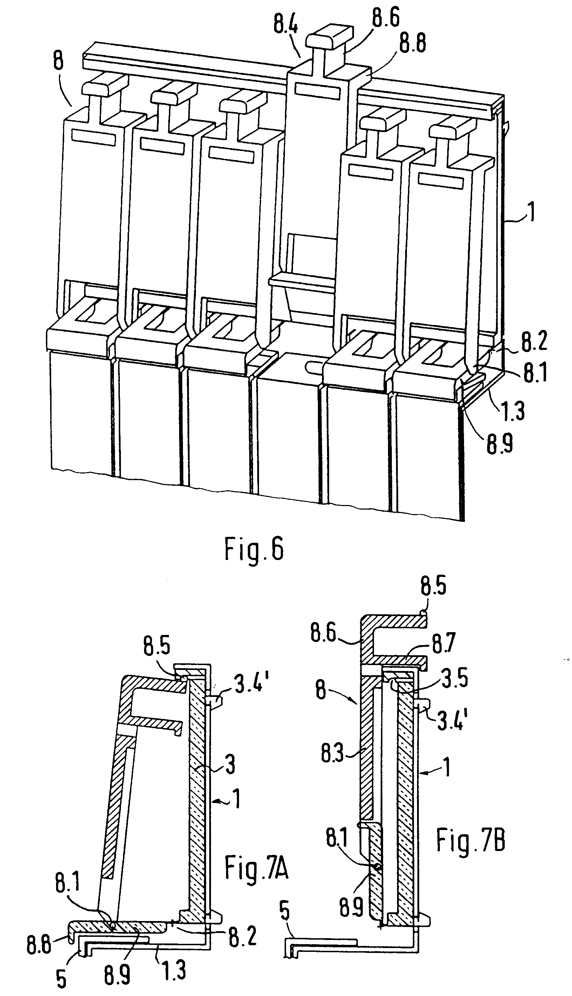

Wie die Fig. 5c) und d) erkennen lassen, wird die Hebelvorrichtung zum Freigeben des Halteabschnitts 5.1 nach oben geschwenkt und kann mit einer hakenartigen Auflage 8.7 auf einem oberen Randbereich oder einer anderen geeigneten Stelle des Grundrahmens 1 eingehängt werden, so daß sich die Steckkarte ungehindert entnehmen bzw. einsetzen läßt. Die Auflage 8.7 ist über einen Stegabschnitt 8.6 an dem Fixierabschnitt 8.4 angeformt. Die Fig. 6 zeigt perspektivisch mehrere Befestigungsteile in Form von Hebelvorrichtungen 8, wobei fünf Hebelvorrichtungen in der Abstützposition und eine Hebelvorrichtung in der Freigabeposition angeordnet sind. Diese beiden Positionen sind auch in den Querschnittsdarstellungen gemäß den Fig. 7A und 7B gezeigt.

Die Fig. 5, 7A und 7B zeigen ferner eine andere Möglichkeit der Festlegung des Basisteils 3 an dem Grundrahmen 1. Hierbei ist das Basisteil 3 mittels an seiner Rückseite vorgesehener Sicherungsabschnitte 3.4' in Form von Rasthaken in der Nähe des oberen und unteren Randes des Basisteils in entsprechenden Aussparungen des Grundrahmens 1 festgelegt, wobei die Sicherungsabschnitte 3.4' gegeneinander gerichtete Rasthaken aufweisen.

Wenn vorliegend von dem Grundrahmen 1 die Rede ist, so ist dieser Ausdruck allgemein zu verstehen und beinhaltet verschiedene Arten von Aufnahmevorrichtungen für Steckkarten, wie z.B. auch ein Chassis. Anstelle des Grundrahmens 1 kann auch eine Wandung oder Bodenplatte eines Gehäuses für die Anordnung von Steckplätzen vorgesehen sein.

## Patentansprüche

1. Haltevorrichtung für in Steckplätzen innerhalb eines Grundrahmens oder Gehäuses eingesetzte Steckkarten, die mit Haltestücken versehen und über diese mittels am Grundrahmen oder Gehäuse ankoppelbarer Befestigungsteile gegen ein Lösen aus den Steckplätzen gesichert sind,
dadurch gekennzeichnet,
daß die Befestigungsteile (4) als steckkartenindividuelle Schieber (4) ausgebildet sind und
daß an dem Grundrahmen (1) oder Gehäuse den Schiebern (4) zugeordnete Schieberaufnahmen (3.6) ausgebildet oder angebracht sind, in die die Schieber (4) in Steckrichtung der Steckkarten (6) einschiebbar und in denen sie verrastbar sind.

2. Haltevorrichtung nach Anspruch 1,
dadurch gekennzeichnet,
daß die Schieberaufnahmen (3.6) in an dem Grundrahmen (1) oder Gehäuse angebrachten individuellen oder für mehrere oder alle Steckplätze einstückig geformten Basisteilen (3) ausgebildet sind.

3. Haltevorrichtung nach Anspruch 1 oder 2,
dadurch gekennzeichnet,
daß die Schieber (4) die seitlich an den Steckkarten (6) angebrachten Haltestücke (5) mit einem quer zur Steckrichtung gerichteten Abschnitt (4.2) übergreifen und
daß an dem freien Endbereich des Abschnitts (4.2) eine in Steckrichtung abgewinkelte Nase (4.3) vorgesehen ist, die in einen zwischen dem Haltestück (5) und dem zugekehrten Rand der Steckkarte (6) vorgesehenen Spalt (5.2) eingreift.

4. Haltevorrichtung nach einem der vorhergehenden Ansprüche,
dadurch gekennzeichnet,
daß das Haltestück (5) einen rechtwinklig von der Steckkarte (6) weg nach außen kragenden Halteabschnitt (5.1) aufweist, der im eingesteckten Zustand der Steckkarte (6) auf einer Abkantung (1.3) des Grundrahmens (1) oder Gehäuses aufliegt und mittels des unteren Abschnitts (4.2) des Schiebers (4) in dessen eingerastetem Zustand gesichert ist.

5. Haltevorrichtung nach einem der vorhergehenden Ansprüche,
dadurch gekennzeichnet,
daß der Schieber (4) zwei im eingeführten Zustand in Steckrichtung verlaufende, senkrecht zu einer zugeordneten Wandung des Grundrahmens (1) oder Gehäuses gerichtete Federschenkel (4.1) aufweist, die an ihren in Steckrichtung liegenden, unteren Enden mittels eines Verbindungsstegs (4.2) miteinander verbunden sind, und
daß auf der Außenseite der Federschenkel (4.1) in Steckrichtung verlaufende, senkrecht nach außen abstehende Führungsstege (4.8) vorgesehen sind, auf deren von den Federschenkeln (4.1) weggerichteten Außenseiten Rastelemente (4.4) vorgesehen sind.

6. Haltevorrichtung nach Anspruch 5,
dadurch gekennzeichnet,
daß zwischen den Federschenkeln (4.1) in deren oberem Bereich ein eingesetztes oder angeformtes Federelement (4.5) vorgesehen ist.

7. Haltevorrichtung nach Anspruch 5 oder 6,
dadurch gekennzeichnet,
daß der Schieber (4) mindestens ein zwischen den Federschenkeln (4.1) angeordnetes Stützelement (4.7) aufweist, das im eingeführten Zustand des Schiebers (4) zur Innenseite eines von dem Grundrahmen (1) oder Gehäuse abgekehrten vorderen Wandabschnitt (3.1) der Schieberaufnahme (3.6) gerichtet ist.

8. Haltevorrichtung nach einem der vorhergehenden Ansprüche,
dadurch gekennzeichnet,
daß die Schieberaufnahme (3.6) von zwei in Steckrichtung verlaufenden, senkrecht zu der zugeordneten Wandung des Grundrahmens (1) oder Gehäuses gerichteten seitlichen Wandabschnitten (3.9) begrenzt ist und daß auf der Innenseite der seitlichen Wandabschnitte (3.9) Gegenrastelemente (3.9) vorgesehen sind.

9. Haltevorrichtung nach einem der vorhergehenden Ansprüche,
dadurch gekennzeichnet,
daß die Rastelemente (4.4) und die Gegenrastelemente (3.3) als Zahnungen mit in Steckrichtung angeordneten flachen und entgegen der Steckrichtung angeordneten steilen Flanken ausgebildet sind.

10. Haltevorrichtung nach Anspruch 8 oder 9,
dadurch gekennzeichnet,
daß die mit seitlichen Führungsnuten (3.7) versehene Schieberaufnahme (3.6) in ihrem mittleren unteren Bereich einen parallel zu den seitlichen Wandabschnitten (3.9) ausgerichteten Mittelsteg (3.8) aufweist, der zum Bilden eines T-förmigen Sicherungshakens auf seiner Vorderseite einen senkrecht daran verlaufenden vorderen Wandabschnitt (3.1) trägt.

11. Haltevorrichtung nach einem der vorhergehenden Ansprüche,
dadurch gekennzeichnet,
daß die Schieber (4) mit den Schieberaufnahmen (3.6) über ein flexibles Band (7) einstückig verbunden sind.

12. Haltevorrichtung für ein in Steckplätzen innerhalb eines Grundrahmens oder Gehäuses eingesetzte Steckkarten, die mit Haltestücken versehen und über diese mittels am Grundrahmen oder Gehäuse ankoppelbarer Befestigungsteile gegen ein Lösen aus den Steckplätzen gesichert sind,
dadurch gekennzeichnet,
daß die Befestigungsteile als steckkartenindividuelle Hebelvorrichtung (8) in Form eines Zweigelenksystems mit einem in Steckrichtung der Steckkarte (6) unteren Gelenkschenkel (8.9) und einem diesen gegen den Grundrahmen (1) oder das Gehäuse abstützenden Stützschenkel (8.3) ausgebildet sind und daß der untere Gelenkschenkel (8.9) im abgestützten Zustand das Haltestück gegen ein Bewegen entgegen der Steckrichtung sichert und im hochgeschwenkten Zustand das Haltestück (5) und damit die Steckkarte (6) freigibt.

13. Haltevorrichtung nach Anspruch 12,
dadurch gekennzeichnet,
daß das Haltestück (5) einen rechtwinklig von der Steckkarte (6) weg nach außen kragenden Halteabschnitt (5.1) aufweist, der im eingesteckten Zustand der Steckkarte (6) auf einer Abkantung (1.3) des Grundrahmens (1) oder Gehäuses aufliegt und mittels des unteren Gelenkschenkels (8.9) im abgestützten Zustand gesichert ist.

14. Haltevorrichtung nach Anspruch 12 oder 13,
dadurch gekennzeichnet,
daß der untere Gelenkschenkel (8.9) auf seiner Unterseite einen Anlageschenkel (8.91), der im abgestützten Zustand flach auf dem Haltestück (5) aufliegt, und einen darüber liegenden Halteschenkel (8.92) aufweist, an dem der Stützschenkel mit seinem unteren Endbereich angelenkt ist, und
daß der dem Grundrahmen (1) oder Gehäuse zugewandte hintere Endbereich des Halteschenkels (8.92) gelenkig mit einem an dem Grundrahmen (1) oder dem Gehäuse angebrachten Basisteil (3) verbunden ist.

15. Haltevorrichtung nach einem der Ansprüche 12 bis 14,
dadurch gekennzeichnet,
daß der nach oben gerichtete Stützschenkel (8.3) mit einem Fixieransatz (8.5) an einer bezüglich des Grundrahmens (1) oder des Gehäuses festen Fixieraufnahme (3.5) abstützbar ist.

16. Haltevorrichtung nach einem der Ansprüche 12 bis 15,
dadurch gekennzeichnet,
daß der obere Bereich des Stützschenkels (8.3) in einen zu dem Grundrahmen (1) oder Gehäuse gerichteten Fixierabschnitt (8.4) ausläuft, der mit seiner hakenartig ausgebildeten Unterseite im hochgeschwenkten Zustand des Halteschenkels (8.92) auf einem oberen Rand oder Auflagebereich des Grundrahmens (1) oder Gehäuses festlegbar ist.

17. Haltevorrichtung nach einem der vorhergehenden Ansprüche,
dadurch gekennzeichnet,
daß die Schieberaufnahmen (3.6) bzw. das Basisteil (3) mittels gegeneinander gerichteter Rasthaken (3.4') in entsprechenden Durchbrüchen des Grundrahmens (1) oder Gehäuses oder mittels einer an dem Grundrahmen (1) oder dem Gehäuse vorgesehenen, den oberen Rand des Basisteils (3) hintergreifenden Lasche (1.1) und mittels einer einen Nocken (3.2) im unteren Bereich des Basisteils (3) aufnehmenden Aussparung des Grundrahmens (1) oder Gehäuses festlegbar sind/ist.
